# EUROPEAN PATENT SPECIFICATION

(11) **EP 2 946 643 B1**
(45) Date of publication and mention of the grant of the patent: **14.02.2024**
(21) Application number: 13871379.7
(22) Date of filing: 19.11.2013
(51) Int. Cl.: G02F 1/1345, H05K 1/11, H05K 1/02, H05K 1/14, H10K 59/131, H10K 59/179

(54) **METHOD AND APPARATUS FOR COUPLING AN ACTIVE DISPLAY PORTION AND SUBSTRATE**
VERFAHREN UND VORRICHTUNG ZUR KOPPLUNG EINES AKTIVEN ANZEIGETEILS UND SUBSTRATS
PROCÉDÉ ET APPAREIL POUR CONNECTER UNE PARTIE D'AFFICHAGE ACTIVE À UN SUBSTRAT

(30) Priority: 18.01.2013 US 201313745409
(43) Date of publication of application: 25.11.2015
(73) Proprietor: Nokia Technologies Oy, 02610 Espoo (FI)
(72) Inventor: MÄÄTTÄ, Esa-Sakari, FI-02650 Espoo (FI)
(74) Representative: Swindell & Pearson Limited
(86) International application number: PCT/FI2013/051084
(87) International publication number: WO 2014/111621

(56) References cited:
- EP-A1- 2 138 892
- EP-A2- 1 109 224
- EP-A2- 1 185 057
- EP-A2- 2 244 539
- KR-A- 20060 027 209
- US-A1- 2005 243 239
- US-A1- 2009 262 277
- US-A1- 2011 050 657
- US-A1- 2012 146 886
- US-A1- 2012 314 383

## Description

### TECHNICAL FIELD

The present application relates generally to displays for electronic devices.

### BACKGROUND

Personal mobile devices are increasingly popular with consumers. A wide variety of mobile devices are available on the market, with smartphones currently being among the most widely adopted mobile devices. The display for mobile devices is an important component which occupies an appreciable amount of device space. In many designs, the display is connected to driver electronics using a flexible circuit, which extends from the front of the display to the driver electronics located behind the display, requiring additional space to accommodate bending of the flexible circuit.

EP2244539 A2 describes a module having a printed circuit board made of dielectric material and comprising a set of connection contacts. A flexible connecting element connects the contacts of the printed circuit board with another set of connection contacts in a component e.g. LCD. The connecting element has a longitudinal section in which conducting paths and the contacts are arranged in a single plane, and another longitudinal section in which the paths and/or the contacts are arranged in two planes. A joint e.g. adhesive joint, is provided between the sections.

EP1185057 A2 describes a connection structure for connecting a display module and a printed substrate. The liquid crystal module is provided with a pin electrode on an external connection terminal of its chip on film (COF), and fixed to a housing in a folded state with respective rear surfaces of the COF and a liquid crystal panel facing each other. A holding member for engaging the printed substrate and holding the printed substrate is formed on the housing. When the holding member engages the printed substrate, the liquid crystal module is fixed to the printed substrate, and at the same time, the pin electrode of the COF and a through hole electrode of the printed substrate are electrically connected.

US 2012/0314383 A1 describes a display device including a second flexible printed circuit board electrically connected to interface terminals, a display panel joined to a first flexible printed circuit board, and a sub panel joined to the second flexible printed circuit board. The second flexible printed circuit board includes an upper end portion which extending sideward from an end portion of the sub panel above the first flexible printed circuit board, an outward bent portion bent from the upper end portion in a return direction, an intermediate portion extending from the outward bent portion such that the intermediate portion passes an electrically connecting portion with the first flexible printed circuit board below the first flexible printed circuit board, an inward bent portion bent from the intermediate portion in a return direction toward the electrically connecting portion, and a lower end portion extending from the inward bent portion and reaching the electrically connecting portion.

US 2009/0262277 A1 describes a flat panel display including a display panel, a mold frame receiving the display panel and a flexible printed circuit including a first portion disposed under the mold frame and a second portion extended from an end of the first portion and connected to the display panel. The first portion of the flexible printed circuit is attached to the mold frame. The mold frame includes a sidewall extending in a first direction, and a receiving plate extended from the sidewall in substantially a second direction perpendicular to the first direction. The receiving plate of the mold frame is disposed between the display panel and the flexible printed circuit.

US 2005/0243239 A1 describes a technique that is capable of preventing a separation of elements of a display panel of a slim display device in which the bending radius of a flexible printed circuit is small. A flexible printed circuit connects to a first side of the display panel and is bent in the vicinity of the first side, part of which is disposed between the back of a backlight and a holder. The holder has an opening or a depression in the vicinity of the first side of the backlight corresponding to the first side of the display panel. The flexible printed circuit has a portion which is deflected so that the top thereof projects into a space in the opening or the depression in the holder, as viewed in section perpendicular to the first side.

EP1109224 A2 discloses a light-emitting device having the quality of an image high in homogeneity. A printed wiring board (second substrate) (107) is provided facing a substrate (first substrate) (101) that has a luminous element (102) formed thereon. A PWB side wiring (second group of wirings) (110) on the printed wiring board (107) is electrically connected to element side wirings (first group of wirings) (103, 104) by anisotropic conductive films (105a, 105b). At this point, because a low resistant copper foil is used to form the PWB side wiring (110), a voltage drop of the element side wirings (103, 104) and a delay of a signal can be reduced. Accordingly, the homogeneity of the quality of an image is improved, and the operating speed of a driver circuit portion is enhanced.

KR20060027209 A discloses a simplified display device of an assembling process. It is accepted in the receiving container and the display panel indicates the image. One side is electrically connected to the display panel so that the first flexible printed circuit board provide the driving signal to the display panel and the other side in which the first terminal is formed is curved in the bottom surface of the receiving container. The second flexible printed circuit board comprises the first flexible printed circuit board, the first terminal it faces, and the second terminal for being electrically connected. The third flexible printed circuit board is interposed between the bottom surface and the second flexible printed circuit board of the receiving container and the third terminal applied about the power source provided from the second flexible printed circuit board is included and the power source is provided to the light source accepted in the receiving container. The bonding member mutually attaches the first flexible printed circuit board and the second flexible printed circuit board. Accordingly, the assembly time of the display device is shortened and the production cost is reduced.

US 2012/146886 A1 discloses a display apparatus, including: a foldable substrate; a pixel array section including a plurality of pixels disposed on the substrate and each including an electro-optical device; the foldable substrate being folded at a substrate end portion at least on one side thereof around the pixel array section; a peripheral circuit section disposed on the substrate end portion and adapted to drive the pixels of the pixel array section; and a pad section provided on the substrate end portion on which the peripheral circuit section is provided and adapted to electrically connect the peripheral circuit section to the outside of the substrate.

US 2011/050657 A1 discloses an electro-optical device including a display panel obtained by forming an electro-optical layer, in which a plurality of pixels is formed, on a glass substrate having a thickness of 50 µm or less; and a support frame supporting the display panel, wherein the display panel has at least a display region in which the plurality of pixels is formed and frame regions formed outside the display region, and wherein at least one side of each of the frame regions is bent from the vicinity of a circumference of the display region to the support frame side and is fixed to the support frame.

EP 2138892 A1 discloses a multilayer display element at low costs with excellent reliability and a method of fabricating the same. It is an object to provide a multilayer display element in which its pixel area is not narrowed, the yields of electrode formation are high, and layer-to-layer interconnection is allowed with no requirement of high temperature processes, and a method of fabricating the same, and to provide a multilayer display element allowing a reduction in the number of externally connected substrates for use and a method of fabricating the same. A multilayer liquid crystal display element 1 has a plurality of data electrode layer-to-layer interconnects 2 formed in a non-display area of a liquid crystal display panel 3 for connecting data electrodes 23r, 23g, and 23b of liquid crystal display panels 3r, 3g, and 3b for R, G, and B to a plurality of data signal input terminals 4 from layer to layer, and a plurality of scanning electrode layer-to-layer interconnects (not shown) formed in the non-display area for connecting scanning electrodes 21r, 21g, and 21b of the liquid crystal display panels 3r, 3g, and 3b for R, G, and B to a plurality of scan signal input terminals from layer to layer.

### SUMMARY

The present invention is as set out in the independent claims. Any examples and features described in this specification that do not fall under the scope of the independent claims are to be interpreted as examples useful for understanding various embodiments of the invention.

Various aspects of examples of the invention are set out in the claims.

According to a first aspect of the present invention, an apparatus comprises a flexible substrate comprising a plurality of conductive traces terminating at a peripheral edge of the flexible substrate. An active display portion is disposed on an upper surface of the flexible substrate and electrically coupled to the conductive traces of the flexible substrate. The peripheral edge of the flexible substrate comprises a protruding region that extends beyond a peripheral edge of the active display portion. A plurality of conductive bonding pads are affixed at the protruding region and coupled to the plurality of the conductive traces. A flexible circuit comprises a plurality of conductors electrically coupled to the plurality of bonding pads at locations on or below a lower surface of the substrate. The protruding region of the flexible substrate folds back on itself. The plurality of bonding pads are affixed to a folded-back portion of the protruding region. The plurality of bonding pads extend from the conductive traces of the flexible substrate, curve around a bend of the folded-back portion of the protruding region, and extend along the folded-back portion of the protruding region. The plurality of conductors of the flexible circuit are electrically coupled to the plurality of bonding pads at the folded-back portion of the protruding region.

According to a second aspect of the present invention, a method involves providing an active display portion disposed on an upper surface of a flexible substrate and electrically coupled to conductive traces of the flexible substrate, wherein a peripheral edge of the flexible substrate comprises a protruding region that extends beyond a peripheral edge of the active display portion. The method also involves affixing a plurality of conductive bonding pads at the protruding region of the flexible substrate, wherein affixing the bonding pads comprises affixing the bonding pads to the upper surface of the flexible substrate at the protruding region, and coupling the conductive traces on the upper surface of the flexible substrate with the bonding pads. The method further involves connecting a plurality of conductors of a flexible circuit to the plurality of bonding pads at locations on or below a lower surface of the flexible substrate. The method further comprises folding a portion of the protruding region that includes the bonding pads on itself, wherein the plurality of bonding pads extend from the conductive traces of the flexible substrate, curve around a bend of the folded-back portion of the protruding region, and extend along the folded-back portion of the protruding region and wherein connecting the plurality of the flexible circuit conductors comprises connecting the plurality of the flexible circuit conductors to the plurality of bonding pads at the folded-back portion of the protruding region.

### BRIEF DESCRIPTION OF THE DRAWINGS

For a more complete understanding of example embodiments of the present invention, reference is now made to the following descriptions taken in connection with the accompanying drawings in which:
Figures 1 and 2 illustrate a display apparatus which includes an active display portion mounted on a substrate and a flexible circuit mounted to an upper surface of the substrate and extending around and below the substrate;
Figures 3 and 4 illustrate a display apparatus having a reduced dead band in accordance with an example embodiment not being part of the present invention;
Figures 5 and 6 illustrate a display apparatus having a reduced dead band in accordance with an embodiment of the present invention;
Figures 7-9 illustrate a display apparatus having a reduced dead band in accordance with a further example not being part of the present invention;
Figure 10 illustrates a method of fabricating a display apparatus having a reduced dead band in accordance with an example embodiment of the present invention;
Figure 11 illustrates a method of fabricating a display apparatus having a reduced dead band in accordance with another example embodiment of the present invention;
Figure 12 illustrates a representative electronic device which incorporates a display apparatus having a reduced dead band in accordance with an example embodiment of the present invention; and
Figure 13 illustrates a representative electronic device which incorporates a display apparatus having a reduced dead band in accordance with another example embodiment of the present invention.

### DETAILED DESCRIPTION

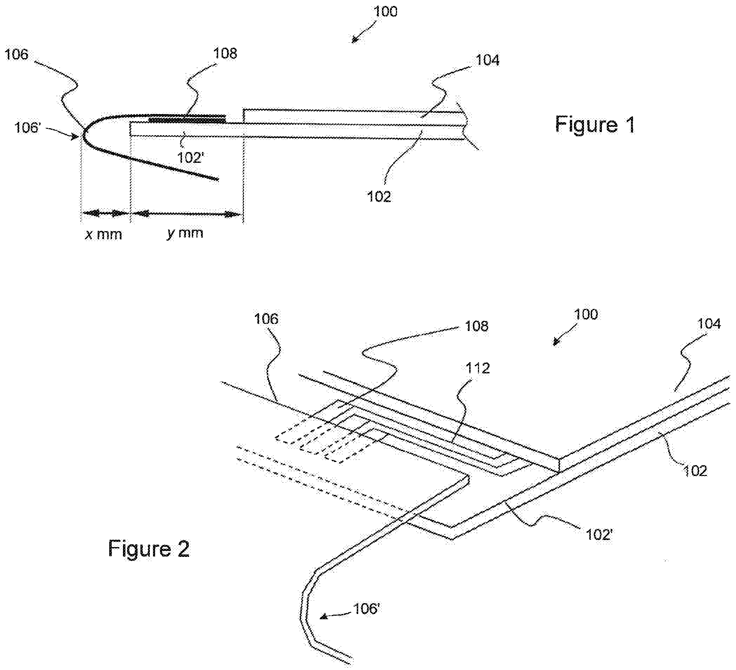

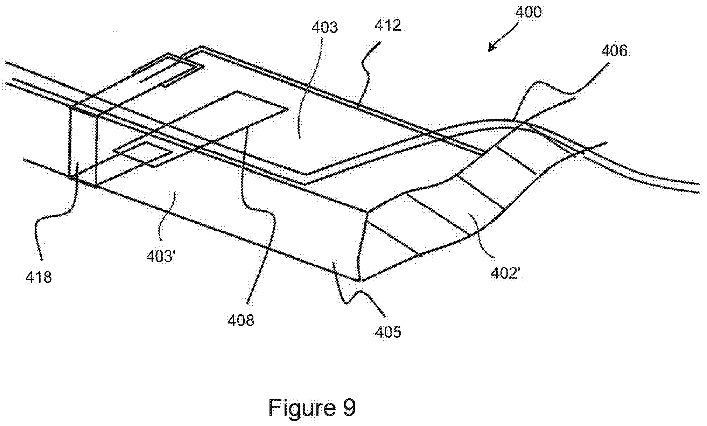

Example embodiments of the present invention and their potential advantages are understood by referring to Figures 1 through 13 of the drawings.

The present disclosure generally relates to displays for electronic devices. In the following description, various example displays are shown which are well-suited for use in mobile and other electronic devices, such as a cellular phone for example. It will be appreciated that the concepts described herein may be applied to a wide variety of devices, such as a tablet computer or other PDA, a navigation device, a media player, a gaming console, etc.

Figure 1 illustrates a display apparatus 100 which includes an active display portion104 mounted on a substrate 102. As best seen in Figure 2, the substrate 102 includes a number of conductive traces 112 which connect to corresponding conductors of the active display portion 104 and terminate near and extended edge 102' of the substrate 102. The area of the extended edge 102' must be sufficient to accommodate a number of bonding pads 108, each of which is electrically connected to one of the conductive traces 112 of the substrate 102. The area of the extended edge 102' must also be sufficient to accommodate one end of a flexible circuit 106 which is connected to the bonding pads 108. The flexible circuit 106 includes a number of spaced-apart wires which terminate at a corresponding one of the bonding pads 108. The flexible circuit 106 is sufficiently resilient to bend around a side of the extended edge 102' to allow for connection with driver electronics (not shown) at the back of the substrate 102.

The space allocated to accommodate the bonding pads 108 and a portion of the flexible circuit 106 is referred to herein as "dead band." In general terms, the dead band represents the portion or portions of a display apparatus that are not part of the active area of the display. This dead band causes problems, such as complicating circuit board/component layout and antenna design, resulting in larger device housings and/or larger visual dead bands. Furthermore, the flexible circuit 106 may not be bent very sharply because this may cause excessive tension forces in the flexible circuit 106, which can break the bonding. The relatively large bending radius needed for the flexible circuit 106 increases dead band. In the context of the display apparatus shown in Figure 1, for example, the dead band of the active display portion 104/substrate 102 is shown as the combination of the length (y mm) of the extended edge 102' of the substrate 102 that projects beyond the active area of the active display portion 104 and the space (x mm) allocated to accommodate the bend 106' of the flexible circuit 106 around the side of the extended edge 102'. For the display configuration shown in Figures 1 and 2, for example, the additional length (*y* mm) of the substrate 102 required for the bonding pad/flexible circuit interface, shown as the extended edge 102', is between about 5 and 6 mm. The additional amount of space (*x* mm) required to accommodate the bend 106' of the flexible circuit 106 is about 2 mm. Accordingly, the dead band for the display apparatus 100 shown in Figures 1 and 2 is between about 7 and 8 mm. Although the dead band is not considered part of the display's active area, the housing of the device which incorporates the display must be enlarged to accommodate the dead band portion of the display apparatus.

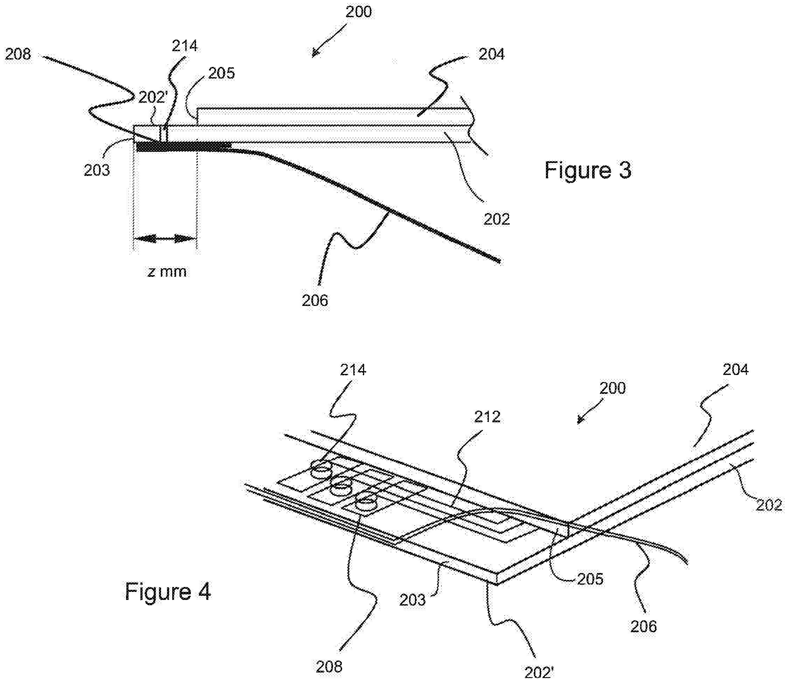

Figures 3 and 4 illustrate a display apparatus 200 having a reduced dead band in accordance with an example not being part of the present invention. In the example shown in Figures 3 and 4, the display apparatus 200 includes a substrate 202 comprising a multiplicity of conductive traces 212 that terminate at a peripheral edge 203 of the substrate 202. The substrate 202 may be flexible or rigid. An active display portion 204 is disposed on an upper surface of the substrate 202, and is electrically coupled to the conductive traces 212 of the substrate 202. The active display portion 204 includes an active area, such as a liquid crystal display (LCD) or an organic LED (OLED). The active display portion 204 may incorporate a touch screen, such as a capacitive, resistive, or force-based touch screen.

The peripheral edge 203 of the substrate 202 comprises a protruding region 202' that extends beyond a peripheral edge 205 of the active display portion 204. A multiplicity of bonding pads 208 are affixed at the protruding region 202' and electrically coupled to the multiplicity of conductive traces 212. A flexible circuit 206 comprises a multiplicity of conductors which are electrically coupled to the multiplicity of bonding pads 208 at the backside of the substrate 202. In the example shown in Figures 3 and 4, the substrate 202 comprises a multiplicity of vertical electrical connections or vias 214, which electrically couple the conductors of the flexible circuit 206 with the bonding pads 208 provided on the backside of the substrate 202.

According to the example shown in Figures 3 and 4, the entire flexible circuit 206 is situated on or below a lower surface of the substrate 202 and orientated inward rather than outward as in the configuration shown in Figures 1 and 2. It can be seen in Figures 3 and 4 that the bonding pads 208 are affixed at the protruding region 202' at locations on or below a plane defined by the lower surface of the substrate 202, and the conductors of the flexible circuit 206 are coupled to the bonding pads 208 at the locations on or below the plane defined by the lower surface of the substrate 202. The example display implementation illustrated in Figures 3 and 4 effectively transposes the bonding pad/flexible circuit interface from the upper surface of the substrate 202 to the lower surface or backside of the substrate 202.

Moving the bonding pads 208 to the backside of the substrate 202/display module 204 eliminates the bend (see bend 106' in Figure 1) in the flexible circuit 206, and also eliminates the dead band space (e.g., x mm shown in Figure 1) allocated to accommodate the flexible circuit bend. By moving the bonding pads 208 to the backside of the substrate 202/display module 204, the size of the protruding region 202' of the substrate 202 can be significantly reduced (e.g., by up to about 50 to 70%), which results in a further reduction in the size of the dead band. For example, the dead band of between about 7-8 mm shown in Figure 1 is reduced to about 3 mm in the example shown in Figures 3 and 4. This significant reduction in the dead band of the display apparatus 200 results in a concomitant reduction in the size of the device housing within which the display apparatus 200 is incorporated (e.g., a total reduction of the dead band in an electronic device, such as a mobile phone, of about 4-5 mm).

According to examples, the bonding pads 208 are configured to make electrical and mechanical connections with the conductive traces 212 provided on the substrate 202 and with the conductors of the flexible circuit 206. The bonding pads 208 include an adhesive, such as a conductive epoxy or acryl, which bonds the conductors of the flexible circuit 206 to the substrate 202 and traces 212. In some examples, the bonding pads 208 comprise an anisotropic conductive adhesive (ACA), such as anisotropic conductive film (ACF).

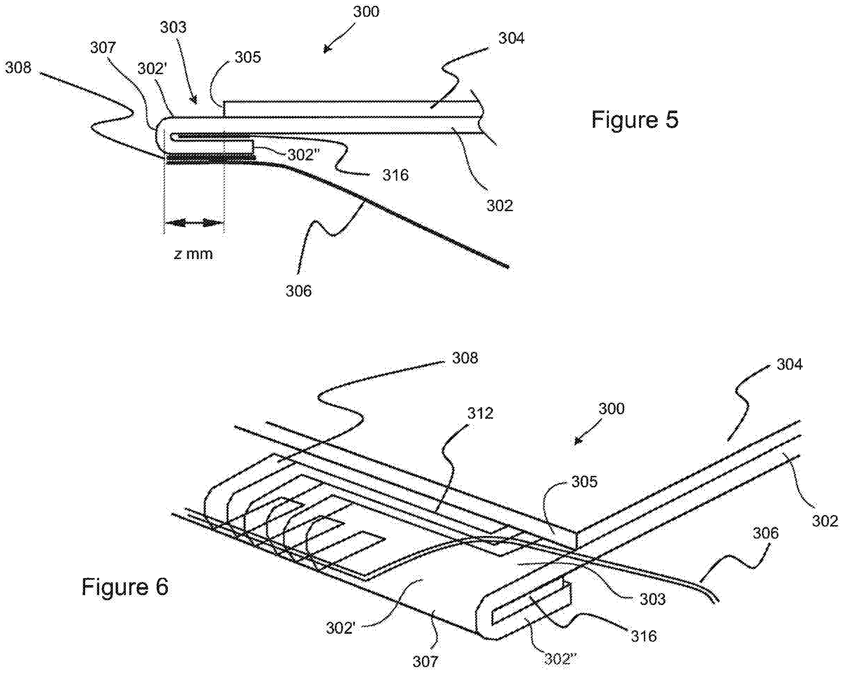

Figures 5 and 6 illustrate a display apparatus 300 having a reduced dead band in accordance with an example embodiment of the present invention. In the example embodiment shown in Figures 5 and 6, the display apparatus 300 includes a flexible substrate 302 comprising a multiplicity of conductive traces 312 that terminate at a peripheral edge 303 of the substrate 302. An active display portion 304 is disposed on an upper surface of the substrate 302, and is electrically coupled to the conductive traces 312 of the substrate 302. The peripheral edge 303 of the substrate 302 comprises a protruding region 302' that extends beyond a peripheral edge 305 of the active display portion 304 and folds back onto itself. The folded-back portion 302" of the protruding region 302' is secured in place by an adhesive 316. A multiplicity of bonding pads 308 are affixed at the protruding region 302' and electrically coupled to the multiplicity of conductive traces 312. In the example embodiment shown in Figures 5 and 6, the bonding pads 308 extend from the conductive traces 312 on the upper surface of the substrate 302, curve around the bend 307 of the protruding region 302', and extend along the folded-back portion 302". The conductors of a flexible circuit 306 are electrically coupled to the multiplicity of bonding pads 308 at the folded-back region 302" of the flexible substrate 302.

In the example embodiment shown in Figures 5 and 6, the entire flexible circuit 306 is situated on or below a lower surface of the flexible substrate 302. It can be seen in Figures 5 and 6 that the bonding pads 308 are affixed at the protruding region 302' at locations on or below a plane defined by the lower surface of the substrate 302 (prior to the bend 307), and the conductors of the flexible circuit 306 are coupled to the bonding pads 308 at the locations on or below the plane defined by the lower surface of the substrate 302. Moving the bonding pads 308 to the backside of the substrate 302/display module 304 eliminates the bend in the flexible circuit 306, eliminates the dead band space allocated to accommodate the flexible circuit bend, eliminates tension at bonding area of the flexible circuit, and provides for a reduction in the size of the laterally projecting portion of the protruding region 302' of the substrate 302 (e.g., by up to about 50 to 70%), which results in a further reduction in the size of the dead band. For example, the dead band of between about 7-8 mm shown in Figure 1 is reduced to about 3 mm in the example embodiment shown in Figures 5 and 6. This significant reduction in the dead band of the display apparatus 300 results in a concomitant reduction in the size of the device housing within which the display apparatus 300 is incorporated.

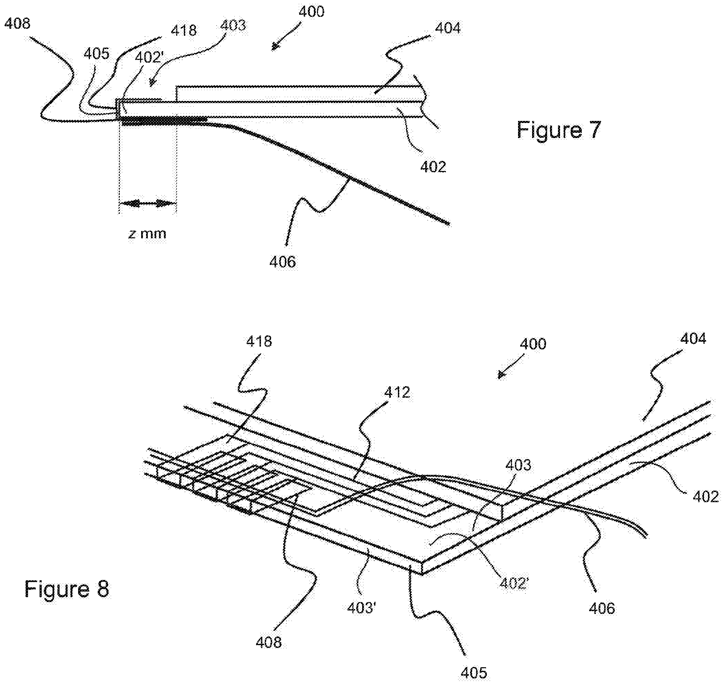

Figures 7-9 illustrate a display apparatus 400 having a reduced dead band in accordance with an example not being part of the present invention. In the example shown in Figures 7-9, the display apparatus 400 includes a configuration suitable for a rigid substrate 402, e.g., a glass substrate. A glass substrate would be difficult to fold over as in Figures 5-6 and it may be difficult to create vias on a glass substrate. The substrate 402 comprises a multiplicity of conductive traces 412 that terminate at a peripheral edge 403 of the substrate 402. An active display portion 404 is disposed on an upper surface of the substrate 402, and is electrically coupled to the conductive traces 412 of the substrate 402. The peripheral edge 403 of the substrate 402 comprises a protruding region 402' that extends beyond a peripheral edge 405 of the active display portion 404. A multiplicity of bonding pads 408 are provided on a lower surface of the substrate 402 at the protruding region 402'. In the example shown in Figures 7-9, printed conductors 418 extend from the conductive traces 412 on the upper surface of the substrate 402, over a side 403' of the protruding region 402', along a portion of the lower surface of the protruding region 402', and terminate at the bonding pads 408. According to an example, the printed conductors 418 comprise printed silver ink conductors. The conductors of a flexible circuit 406 are coupled to the bonding pads 408 on the lower surface of the protruding region 402' of the substrate 402.

In the example shown in Figures 7-9, the entire flexible circuit 406 is situated on or below a lower surface of the substrate 402. It can be seen in Figures 7-9 that the bonding pads 408 are affixed at the protruding region 402' at locations on or below a plane defined by the lower surface of the substrate 402, and the conductors of the flexible circuit 406 are coupled to the bonding pads 408 at the locations on or below the plane defined by the lower surface of the substrate 402. Moving the bonding pads 408 to the backside of the substrate 402/display module 404 eliminates the bend in the flexible circuit 406, eliminates the dead band space allocated to accommodate the flexible circuit bend, and provides for a reduction in the size of the protruding region 402' of the substrate 402 (e.g., by up to about 50 to 70%), which results in a further reduction in the size of the dead band. For example, the dead band of between about 7-8 mm shown in Figure 1 is reduced to about 3 mm in the example shown in Figures 7-9. This significant reduction in the dead band of the display apparatus 400 results in a concomitant reduction in the size of the device housing within which the display apparatus 400 is incorporated.

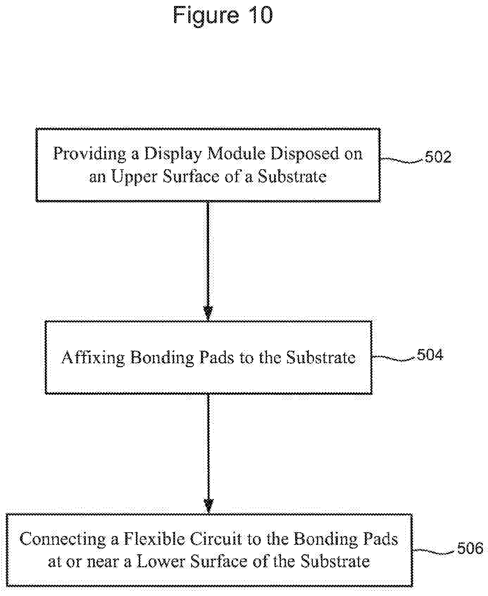

Figure 10 illustrates a method of fabricating a display apparatus having a reduced dead band in accordance with an example embodiment of the present invention. The example method shown in Figure 10 involves providing 502 an active display portion disposed on an upper surface of the substrate, and affixing 504 bonding pads to the substrate. The example method shown in Figure 10 further involves connecting 506 a flexible circuit to the bonding pads at or near a lower surface of the substrate. The example method illustrated in Figure 10 effectively transposes the bonding pad/flexible circuit interface from the upper surface of the substrate to the lower or backside of the substrate, which eliminates the bend in the flexible circuit, eliminates the dead band space allocated to accommodate the flexible circuit bend, and reduces the overall size of the dead band of the display apparatus.

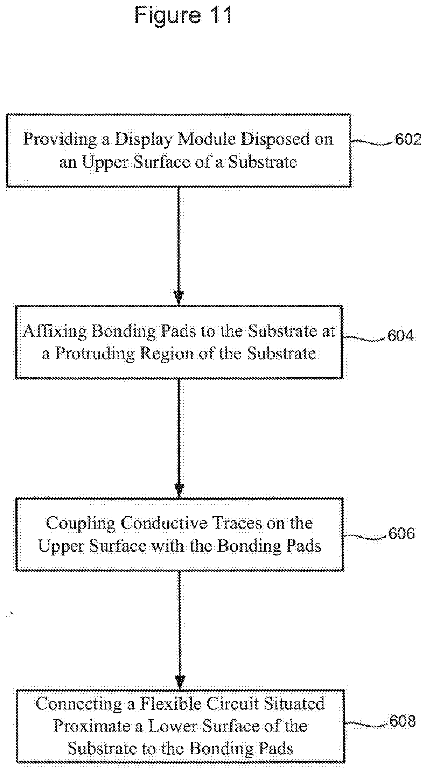

Figure 11 illustrates a method of fabricating a display apparatus having a reduced dead band in accordance with an example embodiment of the present invention. The example method depicted in Figure 11 involves providing 602 an active display portion disposed on an upper surface of the substrate. The example method shown in Figure 11 also involves affixing 604 bonding pads to the substrate at a protruding region of the substrate, and coupling 606 conductive traces on the upper surface with the bonding pads. The example method illustrated in Figure 11 further involves connecting 608 a flexible circuit situated proximate a lower surface of the substrate to the bonding pads. The example method illustrated in Figure 11 effectively transposes the bonding pad/flexible circuit interface from the upper surface of the substrate to the lower or backside of the substrate, which eliminates the bend in the flexible circuit, eliminates the dead band space allocated to accommodate the flexible circuit bend, and reduces the overall size of the dead band of the display apparatus.

According to example embodiments, the methods illustrated in Figures 10 and 11 further involve affixing the bonding pads to the lower surface of the substrate at the protruding region, and forming conductive vias through the substrate at the protruding region, such that the vias couple the conductive traces with the bonding pads. In other example embodiments, the methods illustrated in Figures 10 and 11 further involve affixing the bonding pads to the lower surface of the substrate at the protruding region, and printing electrical conductors that extend from the conductive traces, along a side of the peripheral edge of the substrate, and to the bonding pads. In further example embodiments, the methods illustrated in Figures 10 and 11 further involve affixing the bonding pads to the upper surface of the substrate at the protruding region, folding a portion of the protruding region that includes the bonding pads on itself, and connecting flexible circuit conductors to the bonding pads at the folded portion of the protruding region.

In accordance with an example embodiment, affixing bonding pads to the substrate involves laminating ACF of appropriate dimensions to the substrate. Laminating the ACF involves applying a force to the AFC for a predetermined duration and at an elevated temperature, such as by use of a bondhead. The ACF has a release liner on its rear surface to prevent the bondhead from adhering to the ACF during the lamination procedure. The release liner is removed upon completion of the lamination procedure. The distal ends of the conductors of the flexible circuit are aligned with corresponding bonding pads by looking through the ACF, and then lightly tacked in place either with low heat or no heat under light pressure. The final process involves subjecting the ACF to relatively high heat and pressure, thereby permanently curing the epoxy and attaching the conductors of the flexible circuit to the substrate of the display apparatus. It will be understood that various ACF materials may have different processing parameters, and selection of the appropriate parameters is well within the knowledge of one of ordinary skill in the art. In case of a plastic display, ACF might not be used due to heat and pressure at active portion of the display apparatus. In such a case, conductive glue may be used.

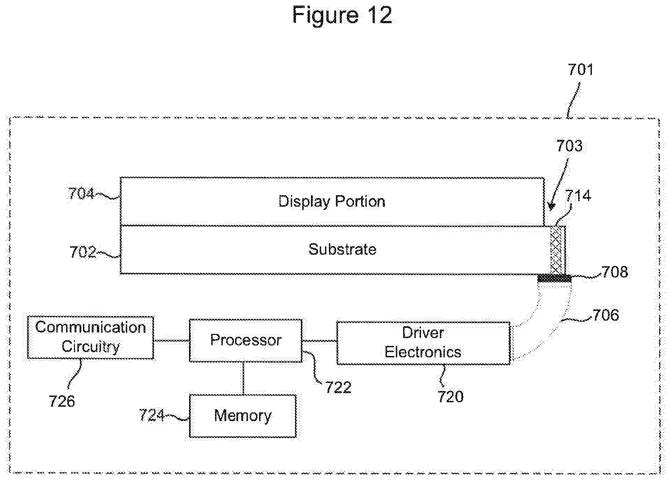

Figure 12 illustrates a representative electronic device 701 which incorporates a display apparatus having a reduced dead band in accordance with an example embodiment of the present invention. The example embodiment of the electronic device 701 includes an active display portion 704 disposed on an upper surface of a substrate 702. The substrate 702 comprises conductive traces that terminate at a protruding peripheral edge 703 of the substrate 702. The substrate 702 may be flexible or rigid. The active display portion 704 includes connectors which electrically couple with the conductive traces of the substrate 702. A flexible circuit 706 is situated at the backside of the substrate 702. The distal ends of the conductors at one end of the flexible circuit 706 are electrically and mechanically coupled to bonding pads 708 affixed to the lower surface of the substrate 702 at the protruding peripheral edge 703. In the example embodiment shown in Figure 12, conductive vias 714 at the protruding peripheral edge 703 of the substrate 702 electrically couple each of the conductive traces with a respective bonding pad 708 and conductor of the flexible circuit 706. It is understood that the connection configurations shown in Figures 5-6 and 7-9 can be used in lieu of the conductive vias 714.

The example electronic device 701 further includes driver electronics 720 coupled to a processor 722. The processor 722, which can be a single core, double-core, or other multi-core processor, is coupled to memory 724 and to communication circuitry 726. The memory 724 stores operating software and, if applicable, one or more apps which can be executed by a user. The communication circuitry 726 includes one or more communication interfaces, such as one or more wireless interfaces (e.g., cellular, Bluetooth, Wi-Fi) and/or wired interfaces (e.g., USB, FIREWIRE, Ethernet). The driver electronics 720 are coupled to the other end of the flexible circuit 706.

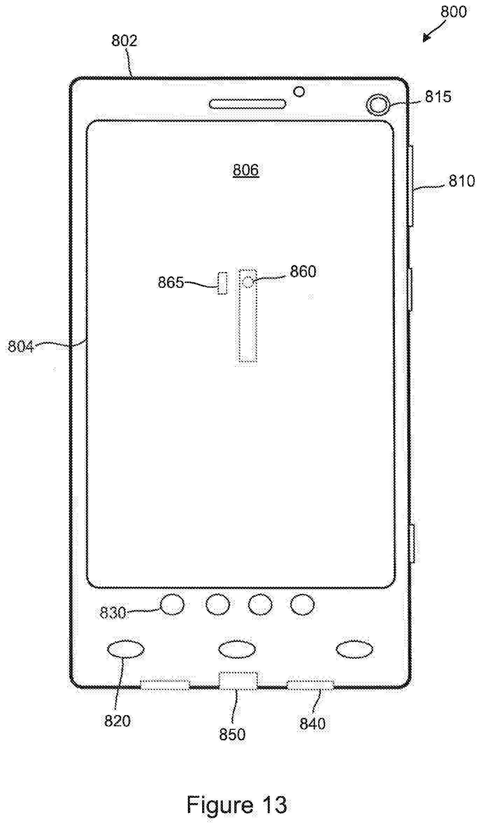

Figure 13 illustrates a representative electronic device which incorporates a display apparatus having a reduced dead band in accordance with an example embodiment of the present invention. The example electronic device 800 shown in Figure 13 comprises a hand-held housing 802 within which various components are housed or supported. A display 804 having a configuration described hereinabove is provided on an upper surface of the electronic device 800. In some configurations, the display 804 is implemented as a display device, such as a liquid crystal display. In other embodiments, the display 804 is implemented as a touch screen, which facilitates tactile interaction with software, applications and other functions supported by the electronic device 800. In other embodiments, the display 804 may be implemented as a hovering sensing display which detects an input, such as a finger, pen or stylus, above the display.

According to various example embodiments, the upper surface of the electronic device 800 comprises a number of soft key buttons 830 and hard key buttons 820 for invoking specified functions or sets of functions. One or more manually actuatable switches 810 are provided along one or more sides of the housing 802 which allow user control of specified functions, such as changing the volume of speakers 840 and turning on and off device power. The housing 802 incorporates an input/output interface connector 850, such as a USB connector. In some embodiments, the electronic device 800 incorporates a first camera 860 (shown in phantom) provided on a lower surface of the housing 802. A flash assembly 865 is provided on the lower surface of the housing 802 proximate the first camera 860. A second camera 815 is optionally provided on the upper surface of the housing 802. According to some embodiments, the electronic device 800 may comprise one or more radios, such as a cellular radio, a Wi-Fi radio, a Bluetooth radio, or other radio technology.

Although various aspects of the invention are set out in the independent claims, other aspects of the invention comprise other combinations of features from the described embodiments and/or the dependent claims with the features of the independent claims, and not solely the combinations explicitly set out in the claims.

It is also noted herein that while the above describes example embodiments of the invention, these descriptions should not be viewed in a limiting sense. Rather, there are several variations and modifications which may be made without departing from the scope of the present invention as defined in the appended claims.

## Claims

1. An apparatus (300), comprising:
a flexible substrate (302) comprising a plurality of conductive traces (312) terminating at a peripheral edge (303) of the flexible substrate;
an active display portion (304) disposed on an upper surface of the flexible substrate and electrically coupled to the conductive traces of the flexible substrate, the peripheral edge of the flexible substrate comprising a protruding region (302') that extends beyond a peripheral edge of the active display portion;
a plurality of conductive bonding pads (308) affixed at the protruding region and coupled to the plurality of the conductive traces;
a flexible circuit (306) comprising a plurality of conductors electrically coupled to the plurality of bonding pads;
wherein the plurality of conductors are electrically coupled to the plurality of bonding pads at locations on or below a lower surface of the flexible substrate;
**characterised in that**:
wherein the protruding region of the flexible substrate folds back on itself;
wherein the plurality of bonding pads are affixed to a folded-back portion (302") of the protruding region;
wherein the plurality of bonding pads extend from the conductive traces of the flexible substrate, curve around a bend (307) of the folded-back portion of the protruding region, and extend along the folded-back portion of the protruding region; and
wherein the plurality of conductors of the flexible circuit are electrically coupled to the plurality of bonding pads at the folded-back portion of the protruding region.

2. The apparatus (300) as claimed in claim 1, wherein the bonding pads comprise an anisotropic conductive adhesive or an anisotropic conductive film.

3. The apparatus (300) as claimed in any of claims 1 or 2, wherein the active display portion (304) comprises an OLED display.

4. The apparatus (300) as claimed in any of claims 1 to 3, wherein the active display portion (304) is one of: a touch screen; and a hovering sensing display.

5. An electronic device (800) comprising the apparatus (300) as claimed in any of claims 1 to 4.

6. A method, comprising:
providing (502, 602) an active display portion disposed on an upper surface of a flexible substrate and electrically coupled to conductive traces of the flexible substrate, a peripheral edge of the flexible substrate comprising a protruding region that extends beyond a peripheral edge of the active display portion;
affixing (504, 604) a plurality of conductive bonding pads at the protruding region of the flexible substrate;
coupling (606) the conductive traces on the upper surface of the flexible substrate with the bonding pads;
connecting (506, 608) a plurality of conductors of a flexible circuit to the plurality of bonding pads;
connecting the plurality of conductors to the plurality of bonding pads at locations on or below a lower surface of the flexible substrate;
**characterised in that**:
wherein affixing (504, 604) the bonding pads comprises affixing the bonding pads to the upper surface of the flexible substrate at the protruding region;
wherein the method further comprises folding a portion of the protruding region that includes the bonding pads on itself;
wherein the plurality of bonding pads extend from the conductive traces of the flexible substrate, curve around a bend (307) of the folded-back portion of the protruding region, and extend along the folded-back portion of the protruding region; and
wherein connecting (506, 608) the plurality of the flexible circuit conductors comprises connecting the plurality of the flexible circuit conductors to the plurality of bonding pads at the folded-back portion of the protruding region.

7. The method as claimed in claim 6, wherein the bonding pads comprise an anisotropic conductive adhesive or an anisotropic conductive film.

8. The method as claimed in any of claims 6 or 7, wherein the active display portion (304) comprises an OLED display.

9. The method as claimed in any of claims 6 to 8, wherein the active display portion (304) is one of: a touch screen; and a hovering sensing display.

## Patentansprüche

1. Einrichtung (300), die Folgendes umfasst:
ein flexibles Substrat (302), das eine Vielzahl von leitfähigen Leiterbahnen (312) umfasst, die an einer Umfangskante (303) des flexiblen Substrats enden;
einen aktiven Anzeigeabschnitt (304), der auf einer Oberfläche des flexiblen Substrats angeordnet und elektrisch an die leitfähigen Leiterbahnen des flexiblen Substrats gekoppelt ist, wobei die Umfangskante des flexiblen Substrats eine vorstehende Region (302') umfasst, die sich über eine Umfangskante des aktiven Anzeigeabschnitts hinaus erstreckt;
eine Vielzahl von leitfähigen Bondingauflagen (308), die an der vorstehenden Region befestigt und an die Vielzahl von leitfähigen Leiterbahnen gekoppelt sind;
eine flexible Schaltung (306), die eine Vielzahl von Leitern umfasst, die elektrisch an die Vielzahl von Bondingauflagen gekoppelt sind;
wobei die Vielzahl von Leitern an Stellen auf oder unter einer unteren Fläche des flexiblen Substrats elektrisch an die Vielzahl von Bondingauflagen gekoppelt sind;
**dadurch gekennzeichnet, dass**:
wobei die vorstehende Region des flexiblen Substrats auf sich selbst umgeklappt ist;
wobei die Vielzahl von Bondingauflagen an einem umgeklappten Abschnitt (302") der vorstehenden Region befestigt sind;
wobei sich die Vielzahl von Bondingauflagen von den leitfähigen Leiterbahnen des flexiblen Substrats erstrecken, einer Krümmung (307) des umgeklappten Abschnitts der vorstehenden Region folgen, und sich entlang des umgeklappten Abschnitts erstrecken; und
wobei die Vielzahl von Leitern der flexiblen Schaltung elektrisch an die Vielzahl von Bondingauflagen am umgeklappten Abschnitt der vorstehenden Region gekoppelt sind.

2. Einrichtung (300) nach Anspruch 1, wobei die Bondingauflagen einen anisotropen leitfähigen Kleber oder einen anisotropen leitfähigen Film umfassen.

3. Einrichtung (300) nach einem der Ansprüche 1 oder 2, wobei der aktive Anzeigeabschnitt (304) eine OLED-Anzeige umfasst.

4. Einrichtung (300) nach einem der Ansprüche 1 bis 3, wobei der aktive Anzeigeabschnitt (304) eines von Folgendem ist: ein Touchscreen; und eine Schwebungserfassungsanzeige.

5. Elektronische Vorrichtung (800), die die Einrichtung (300) nach einem der Ansprüche 1 bis 4 umfasst.

6. Verfahren, das Folgendes umfasst:
Bereitstellen (502, 602) eines aktiven Anzeigeabschnitts, der auf einer Oberfläche eines flexiblen Substrats angeordnet und elektrisch an leitfähige Leiterbahnen des flexiblen Substrats gekoppelt ist, wobei eine Umfangskante des flexiblen Substrats eine vorstehende Region umfasst, die sich über eine Umfangskante des aktiven Anzeigeabschnitts hinaus erstreckt;
Befestigen (504, 604) einer Vielzahl von leitfähigen Bondingauflagen an der vorstehenden Region des flexiblen Substrats;
Koppeln (606) der leitfähigen Leiterbahnen mit den Bondingauflagen an die Oberfläche des flexiblen Substrats;
Verbinden (506, 608) einer Vielzahl von Leitern einer flexiblen Schaltung mit der Vielzahl von Bondingauflagen;
Verbinden der Vielzahl von Leitern an Stellen auf oder unter einer unteren Fläche des flexiblen Substrats mit der Vielzahl von Bondingauflagen;
**dadurch gekennzeichnet, dass**:
wobei das Befestigen (504, 604) der Bondingauflagen das Befestigen der Bondingauflagen an der Oberfläche des flexiblen Substrats an der vorstehenden Region umfasst;
wobei das Verfahren ferner das Umklappen eines Abschnitts der vorstehenden Region, der die Bondingauflagen beinhaltet, auf sich selbst umfasst;
wobei sich die Vielzahl von Bondingauflagen von den leitfähigen Leiterbahnen des flexiblen Substrats erstrecken, einer Krümmung (307) des umgeklappten Abschnitts der vorstehenden Region folgen und sich entlang des umgeklappten Abschnitts erstrecken; und
wobei das Verbinden (506, 608) der Vielzahl der flexiblen Schaltungsleiter das Verbinden der Vielzahl der flexiblen Schaltungsleiter mit der Vielzahl von Bondingauflagen am umgeklappten Abschnitt der vorstehenden Region umfasst.

7. Verfahren nach Anspruch 6, wobei die Bondingauflagen einen anisotropen leitfähigen Kleber oder einen anisotropen leitfähigen Film umfassen.

8. Verfahren nach einem der Ansprüche 6 oder 7, wobei der aktive Anzeigeabschnitt (304) eine OLED-Anzeige umfasst.

9. Verfahren nach einem der Ansprüche 6 bis 8, wobei der aktive Anzeigeabschnitt (304) eines von Folgendem ist: ein Touchscreen; und eine Schwebungserfassungsanzeige.

## Revendications

1. Appareil (300), comprenant :
un substrat flexible (302) comprenant une pluralité de pistes conductrices (312) se terminant au niveau d'un bord périphérique (303) du substrat flexible ;
une partie d'affichage active (304) disposée sur une surface supérieure du substrat flexible et couplée électriquement aux pistes conductrices du substrat flexible, le bord périphérique du substrat flexible comprenant une région en saillie (302') qui s'étend au-delà d'un bord périphérique de la partie d'affichage active ;
une pluralité de plots de contact conducteurs (308) fixés au niveau de la région en saillie et couplés à la pluralité de pistes conductrices ;
un circuit flexible (306) comprenant une pluralité de conducteurs couplés électriquement à la pluralité de plots de contact ;
dans lequel la pluralité de conducteurs sont couplés électriquement à la pluralité de plots de contact à des emplacements sur ou sous une surface inférieure du substrat flexible ;
**caractérisé en ce que** :
dans lequel la région en saillie du substrat flexible se replie sur elle-même ;
dans lequel la pluralité de plots de contact sont fixés au niveau d'une partie repliée (302") de la région en saillie ;
dans lequel la pluralité de plots de contact s'étendent depuis les pistes conductrices du substrat flexible, se courbent autour d'un coude (307) de la partie repliée de la région en saillie, et s'étendent le long de la partie repliée de la région en saillie ; et
dans lequel la pluralité de conducteurs du circuit flexible sont couplés électriquement à la pluralité de plots de contact au niveau de la partie repliée de la région en saillie.

2. Appareil (300) selon la revendication 1, dans lequel les plots de contact comprennent un adhésif conducteur anisotrope ou un film conducteur anisotrope.

3. Appareil (300) selon la revendication 1 ou 2, dans lequel la partie d'affichage active (304) comprend un affichage OLED.

4. Appareil (300) selon l'une quelconque des revendications 1 à 3, dans lequel la partie d'affichage active (304) est l'un parmi : un écran tactile ; et un affichage à détection de passage.

5. Dispositif électronique (800) comprenant l'appareil (300) selon l'une quelconque des revendications 1 à 4.

6. Procédé, comprenant :
la fourniture (502, 602) d'une partie d'affichage active disposée sur une surface supérieure d'un substrat flexible et couplée électriquement à des pistes conductrices du substrat flexible, un bord périphérique du substrat flexible comprenant une région en saillie qui s'étend au-delà d'un bord périphérique de la partie d'affichage active ;
la fixation (504, 604) d'une pluralité de plots de contact conducteurs à la région en saillie du substrat flexible ;
le couplage (606) des pistes conductrices sur la surface supérieure du substrat flexible avec les plots de contact ;
la connexion (506, 608) d'une pluralité de conducteurs d'un circuit flexible à la pluralité de plots de contact ;
la connexion de la pluralité de conducteurs à la pluralité de plots de contact à des emplacements sur ou sous une surface inférieure du substrat flexible ;
caractérisé en ce :
dans lequel la fixation (504, 604) des plots de contact comprend la fixation des plots de contact à la surface supérieure du substrat flexible au niveau de la région en saillie ;
dans lequel le procédé comprend en outre le pliage sur elle-même d'une partie de la région en saillie qui comporte les plots de contact ;
dans lequel la pluralité de plots de contact s'étendent depuis les pistes conductrices du substrat flexible, se courbent autour d'un coude (307) de la partie repliée de la région en saillie, et s'étendent le long de la partie repliée de la région en saillie ; et
dans lequel la connexion (506, 608) de la pluralité du conducteurs de circuit flexible comprend la connexion de la pluralité du conducteurs de circuit flexible à la pluralité de plots de contact au niveau de la partie repliée de la région en saillie.

7. Procédé selon la revendication 6, dans lequel les plots de contact comprennent un adhésif conducteur anisotrope ou un film conducteur anisotrope.

8. Procédé selon l'une quelconque des revendications 6 ou 7, dans lequel la partie d'affichage active (304) comprend un affichage OLED.

9. Procédé selon l'une quelconque des revendications 6 à 8, dans lequel la partie d'affichage active (304) est l'un parmi : un écran tactile ; et un affichage à détection de passage.
